# EUROPEAN PATENT APPLICATION

(11) **EP 4 576 611 A1**
(43) Date of publication of application: **25.06.2025**
(21) Application number: 24195037.7
(22) Date of filing: 16.08.2024
(51) Int. Cl.: H04B 10/70

(54) **OPTICAL DEVICES, AN OPTICAL TRANSMITTER AND AN OPTICAL QUANTUM RANDOM NUMBER GENERATOR**

(30) Priority: 22.12.2023 GB 202319944
(71) Applicant: Kabushiki Kaisha Toshiba, Minato-ku Tokyo (JP)
(72) Inventor: PARAISO, Taofiq Kolawole, Cambridge, CB4 0GZ (GB); SHIELDS, Andrew James, Cambridge, CB4 0GZ (GB)
(74) Representative: Marks & Clerk LLP

(57) **Abstract**

An optical device comprises a semiconductor laser having a first output facet and a second output facet. The laser is configured to emit coherent light from both the first output facet and the second output facet. The optical device further comprises a first optical channel coupled to the first output facet of the laser, a second optical channel coupled to the second output facet of the laser, and an optical combiner configured to combine the first and the second optical channel into a combiner output channel.

## Description

### Technical Field

Embodiments described herein relate to optical devices, for example optical transmitters and optical quantum random number generators.

### Background

Optical devices are widely deployed in modern optical telecommunication systems and computing systems. It is known for optical devices to include a semiconductor laser diode as a primary light source which provides optical signals to other components of the device. It is typically desirable to reduce the footprint and to increase the efficiency of such devices. Optical devices of increasing interest include optical Quantum Random Number Generators (QRNG) and optical transmitters for quantum communication.

QRNG generate sequences of random numbers for use in a variety of applications including cryptography and numerical simulations. In optical QRNG, the source of randomness is physical and relies on the unpredictability of a measurement, and, in particular, the unpredictability relies on a quantum mechanical property of light.

In a quantum communication system, information is sent between a transmitter and a receiver by encoded single quanta, such as single photons. Each photon carries one bit of information encoded upon a property of the photon, such as its polarization, phase or energy/time. A quantum communication system may be used to implement quantum key distribution (QKD) which is a technique for sharing of cryptographic keys between two parties; a transmitter, often referred to as "Alice", and a receiver, often referred to as "Bob". The attraction of this technique is that it provides a test of whether any part of the key can be known to an unauthorised eavesdropper, often referred to as "Eve".

### Brief Description of the Drawings

Embodiments of the invention will now be described, by way of example only, with reference to the accompanying schematic drawings, in which:
Figure 1 is a schematic illustration of an optical device according to an embodiment;
Figure 2 is a schematic illustration of an adjustable coupler of the optical device of Figure 1;
Figure 3 is a schematic illustration of a further optical device according to an embodiment;
Figure 4A is a schematic illustration of an optical device for a QRNG according to a comparative example;
Figure 4B is a schematic illustration of a quantum transmitter according to a comparative example;
Figure 5 is a schematic illustration of an optical transmitter according to an embodiment;
Figure 6 is a schematic illustration of an optical communication system according to an embodiment;
Figure 7 is a schematic illustration of an optical device for a QRNG according to an embodiment, and
Figure 8 shows the digitisation and processing of the output of the photodetector to obtain random numbers.

To avoid unnecessary repetition, like reference numerals will be used to denote like features in the figures.

### Detailed Description

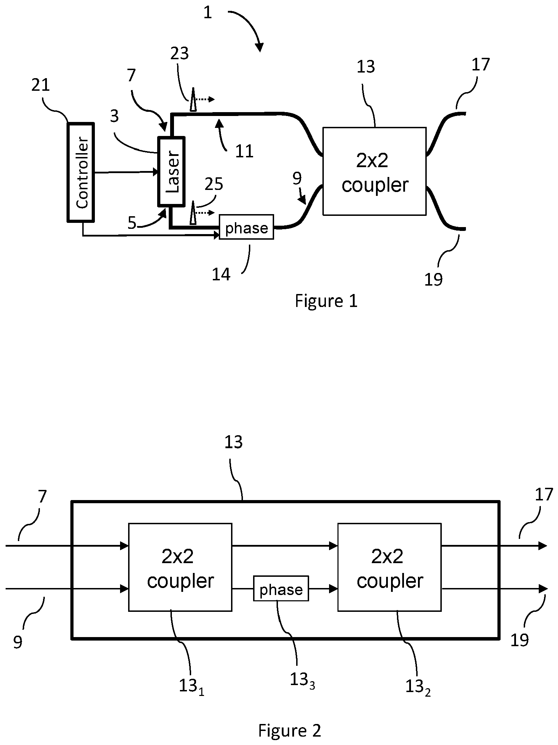

The present disclosure aims to provide new and useful optical devices. In particular, embodiments may enable compact devices such as compact Quantum Random Number Generators (QRNG) and compact optical transmitters for quantum communication. Further, embodiments may be more resource-efficient than conventional designs. As described below with reference to Figures 1 to 3 and Figures 5 to 8, the proposed devices achieve this by using coherent light emitted from two output facets of a chip-based semiconductor laser.

In an embodiment, an optical device is provided. The optical device comprises a semiconductor laser (e.g. a distributed feedback laser, a Fabry-Perot laser diode or the like) having a first output facet (e.g. the front facet of the laser chip) and a second output facet (e.g. the rear facet of the laser chip). The laser is configured to (simultaneously) emit coherent light from both the first output facet and the second output facet. The optical device further comprises a first optical channel coupled to the first output facet of the laser, a second optical channel coupled to the second output facet of the laser, and an optical combiner configured to combine the first and the second optical channel into a combiner output channel.

In an embodiment, the first or the second optical channel may comprise a delay element such as a delay line.

In an embodiment, the first or the second optical channel may comprise a polarisation controlling element configured to control an optical polarisation of the coherent light propagating in the respective channel.

In an embodiment, the first or the second optical channel may comprise a frequency controlling element configured to control the optical frequency of the coherent light propagating in the respective channel.

In an embodiment, the first or the second optical channel may comprise an intensity controlling element (e.g. an electro-absorption modulator, a Mach-Zehnder modulator, a semiconductor optical amplifier or an optical switch or the like) configured to control the intensity of the coherent light propagating in the respective optical channel.

In an embodiment, the first or the second optical channel may comprise a phase controlling element configured to provide a phase shift to the coherent light propagating in the respective channel.

In an embodiment, the optical combiner may be an adjustable optical combiner configured to combine, based on an adjustable combining ratio, the coherent light emitted by the first and the second optical channel into the combiner output channel. In this case, the optical combiner may comprise a Mach-Zehnder interferometer for adjusting the combining ratio. The adjustable optical combiner may comprise a first and a second combiner output channel and combine the coherent light in the first and the second optical channel into the first and second combiner output channels based on the adjustable combining ratio.

In an embodiment, the semiconductor laser may be a gain-switched laser and configured to emit the stream of optical pulses such that the phase of each pulse in the stream of pulses is randomised.

In an embodiment, the optical device may further comprise an optical detector coupled to the combiner output channel.

In an embodiment, the optical device may further comprise a seed laser optically coupled to the combiner output channel to simultaneously seed the semiconductor laser via the first output facet and via the second output facet.

In an embodiment, the first or the second optical channel comprises a phase controlling element configured to provide a phase shift to the coherent light propagating in the respective channel, and the optical combiner may comprise a first and a second combiner output channel (i.e. the combiner may be a 2x2 combiner) and the phase shift provided by the phase controlling element is selected so that, at the optical combiner, light from the first and second optical channels interferes to be combined into only one of the first and a second combiner output channels.

In an embodiment, the optical device may further comprise a semiconductor substrate. The semiconductor laser, the first and second optical channels and the optical combiner may be integrated on the semiconductor substrate to form a photonic integrated circuit.

In an embodiment, an optical quantum random number generator is provided. The optical quantum random number generator comprises the optical device and processing circuitry to generate random numbers from numerical values provided by the optical detector. In this case, the semiconductor laser may be a gain-switched laser configured to emit the stream of optical pulses such that the phase of each pulse in the stream of pulses is randomised. The first or the second optical channel may comprise a delay element providing a delay time equal to an integer multiple of a temporal separation between pulses in the stream of pulses emitted by the gain-switched laser.

In an embodiment, the delay element may provide a delay time equal to the temporal separation between pulses in the stream of pulses emitted by the gain-switched laser so that successive optical pulses are interfered by the optical combiner to convert a phase difference between successive optical pulses into an intensity modulation of an output optical signal provided to the optical detector via the combiner output channel.

In an embodiment, an optical transmitter for quantum communication is provided. The optical transmitter comprises the optical device.

In an embodiment, the optical transmitter may be configured to perform quantum state encoding to generate, from an optical pulse emitted from the first output facet of the laser and a corresponding pulse emitted from the second facet output of the laser, a time-bin encoded quantum state, a frequency encoded quantum state, a polarisation-encoded quantum state, a path-encoded quantum state or a phase-encoded quantum state.

Figure 1 shows an example optical device 1 according to an embodiment. The optical device 1 is provided as an integrated device (and described as such in the following), i.e. the components of the device 1 are integrated on a common semiconductor substrate (or on multiple semiconductor substrates that are appropriately assembled/connected). However, in other embodiments, the optical device 1 may also be implemented using discrete (optical fibre pigtailed or free-space) components.

The optical device 1 comprises a semiconductor laser 3 and a controller 21 for controlling the operation of the semiconductor laser 3. The semiconductor laser 3 is operative to emit coherent light. For example, the semiconductor laser 3 may be operated in continuous wave operation or in pulsed operation (i.e. to emit a stream of optical pulses; e.g. nanosecond or picosecond long pulses). When operated in pulsed mode, the semiconductor laser 3 may be driven (by the controller 21) at a fixed repetition rate to output a steam of pulses having well-defined pulse durations and well-defined, regular temporal spacings.

The semiconductor laser 3 can be a gain-switched semiconductor laser driven to output a stream of phase randomised pulses (i.e. each pulse from the stream of pulses may have a random phase). In general, a gain-switched laser generates light when the laser is switched above the lasing threshold and generates almost no light when the laser is switched below the lasing threshold. Thus, the controller 21 may control a modulation of the gain of the laser 3 by modulating an electrical drive current applied to the laser 3 in a time varying manner. For example, the semiconductor laser 3 may be periodically switched above and below the lasing threshold by application of a time varying current. In this manner, the laser generates light pulses. It is to be understood that the controller 21 may comprise (or is connected to) appropriate driving circuitry to generate and apply such a time varying current.

The semiconductor laser 3 comprises a first output facet 5 and a second output facet 7. Typically, the semiconductor laser 3 comprises a laser chip having a front facet corresponding to the first output facet 5 and rear facet corresponding to the second output facet 7 (thus the first and second output facets are referred to as front and rear outputs 5, 7 hereafter). In more general terms, the front output 5 and the rear output 7 correspond to (or are optically coupled to) a front and rear end of a laser resonator portion of the semiconductor laser 3. As one example, the semiconductor laser 3 may be a Fabry-Perot laser diode comprising a laser resonator portion that comprises a gain element between a first and a second partially reflective surfaces/elements. In this case, the front output 5 may correspond to the first partially reflective surface/element and a rear output 7 may correspond to the second partially reflective surface/element. As another example, the semiconductor laser 3 may be a distributed-feedback (DFB) laser comprising, as laser resonator portion, a periodically structured gain element. In this case, a front facet of the gain element may correspond to the front output 5, and a rear facet of the gain element may correspond to the rear output 5.

During operation, i.e. when the semiconductor laser 3 generates light, the semiconductor laser 3 emits light from both the front output 5 and the rear output 7. For example, in embodiments where the semiconductor laser 3 is driven (by the controller 21) at a repetition rate to emit a stream of optical pulses, the laser 3 emits, at each cycle, an optical pulse (simultaneously) from each of the front and rear outputs 5, 7. Thus, in this case, two optical pulses are generated in each cycle. Figure 1 illustrates a pair of corresponding pulses 23, 25 generated in the same cycle and exiting respectively from the front and the rear output 5, 7. In general, since the corresponding pulses 23, 25 are emitted from different output ports of the semiconductor laser 3, the pulses 23, 25 are emitted in different directions. Two output ports are provided at opposite ends of the laser resonator portion which is typically a linear portion (i.e. the laser resonator portion is typically straight and not curved). Thus, in these cases, the corresponding pulses 23, 25 are emitted in opposite directions (e.g. forwards and rearwards with respect to the semiconductor laser 3).

In broad terms, the coherent light emitted from the outputs 5, 7 has the same optical frequency and a well-defined phase relationship (e.g. the coherent light emitted from the outputs 5, 7 can have the same phase or a well-defined relative phase offset). This is because the coherent light emitted from the outputs 5, 7 is generated in the same lasing process. More specially, when the laser 3 is pulsed to emit a stream of optical pulses, the pulses of the pulse pair 23, 25 are intrinsically correlated due to the (common) generation process, i.e. because they are generated during the same lasing process. For example, the pulses of the pulse pair 23, 25 have generally the same optical properties (e.g. the same optical frequency), and the pulses of the pulse pair 23, 25 have a fixed phase relation to each other. Conceptually, one may consider the pulses of the pulse pair 23, 25 to be two (counter-propagating) portions of the same pulse.

The semiconductor laser 3 may be configured (e.g. by appropriately designing the laser resonator portion of the laser) so that the front output 5 and the rear output 7 emit light having substantially the same optical intensity (e.g. the average photon numbers of the corresponding pulses 23, 25 may be substantially the same). In embodiments, a ratio of the intensities of the light respectively emitted from the front output 5 and from the rear output 7 may be in a range between 0.5 to 2, and preferably in a range between 0.8 and 1.2.

The optical device 1 further comprises a first optical channel 9 coupled to the front output 5 of the laser 3 to receive light emitted from the front output 5. Similarly, the optical device 1 further comprises a second optical channel 11 coupled to the rear output 7 of the laser 3 so as to receive light emitted from the rear output 7. The first and second optical channels 9, 11 may be integrated optical waveguides.

The optical device 1 further comprises an integrated beam splitter (or optical "2x2 coupler") 13 comprising two input ports respectively coupled to the first and second optical channels 9, 11 and two output ports. The optical coupler 13 is configured to combine optical signals in the first and second optical channels 9, 11 and to output the combined signals into output channels 17, 19 (i.e. light emitted from the front and rear outputs 5, 7 can interfere at the optical coupler 13). The coupler 13 may combine the optical signals in the first and second optical channels 9, 11 based on a combining ratio (e.g. 50:50). As described below, in some embodiments, coupler 13 has an adjustable combining ratio. Further, in some embodiments, the coupler 13 may be provided as a "2x1 coupler", i.e. comprising two input ports and one output port.

The coupler 13 may be implemented in any known and suitable way. As one example, in an embodiment, the coupler 13 may use evanescent coupling to couple light from one waveguide into one or several other waveguides. In this embodiment, the optical combiner 13 comprises optical waveguides that, at the input ports of the coupler 13, are respectively coupled to the first and second optical channels 9, 11. The coupler 13 may comprise a contact region in which these waveguides are arranged in close contact. In the contact region, light may evanescently couple from one waveguide into the other waveguide in an oscillatory manner, i.e. the length of the coupling region determines how much light is coupled from one waveguide into the other waveguide. In other words, the length of the coupling region may determine the splitting ratio. The length of the coupling region can be such that, for example, 50% of the light is coupled from one waveguide to the other. In other embodiments, the coupler 13 may be realised using a different method to split the signals (i.e. the coupler 13 does not necessarily use evanescent coupling).

As another example, in an embodiment, the coupler 13 may comprise a multi-mode interference (MMI) coupler. A MMI coupler comprises single-mode inputs/outputs, and a multi-mode section coupled between the inputs and outputs. Light is inserted from a single-mode input waveguide into the multi-mode waveguide region and interference between several modes excited in the multi-mode waveguide region leads to the generation of self-images of the input light distribution for certain propagation distances in the multi-mode waveguide region. The output single-mode waveguides are positioned at a suitable distance to the input waveguides to couple light from the input with a certain intensity distribution into the output waveguides. For example, a 2x2 coupler can be designed such that the length of the multi-mode waveguide region generates two lobes (e.g. each with 50% of the each of the input light pulses). At the position where these lobes are generated, the output single-mode waveguides are placed.

The optical device further comprises a phase controlling element 14 in the optical channel 9. The phase controlling element 14 is configured to provide a phase shift to the coherent light propagating in the optical channel 9. Thus, the phase controlling element 14 allows controlling a phase difference between the light emitted from the front output 5 (i.e. light propagating in the first optical channel 9) and the light emitted from the rear output 7 (i.e. light propagating in the second optical channel 11). By controlling this phase difference, the interference at the coupler 13 can be controlled (i.e. the interference by the optical combiner 13 converts a phase difference between the light emitted from the front output 5 and the light emitted from the rear output 7 into an intensity modulation of the output optical signals provided to the combiner output channels 17, 19). For example, the phase controlling element 14 may provide a phase shift is so that the light emitted by the front output 5 and the light emitted by the rear output 7 interferes at the coupler so that substantially all light is output to the output channel 17 (and substantially no light is output to the output channel 19). The phase controlling element 14 may be used to dynamically (i.e. during use) change the provided phase shift to adjust the output intensities at the output channels 17 and 19 according to a desired target intensity output distribution. The controller 21 may be further configured to control or adjust phase shift provided by the phase controlling element.

Thus, the optical device 1 enables using light emitted from both lasers output 5, 7 for applications (i.e. light emitted from both laser outputs is available to optical components downstream to the output channels 17, 19). This is in contrast to known designs in which only the light emitted from the front facet is used for applications. In these designs, light emitted from the rear facet of the laser chip is not available for application because it is either just lost (i.e. absorbed) or detected by a photodetector to track the optical output power of the laser. While it is known to provide a highly reflective rear facet to channel the entire laser output to the front facet, such designs are complex (and thus more expensive) to manufacture. The optical device 1 provides a simple and elegant solution to the problem of "wasted" output power from the rear facet of the laser chip.

Before describing specific use-cases for the above described optical device 1, it is noted that embodiments may comprise further elements. For example, the optical losses accumulated in the first optical channel 9 compared to the second optical channel 11 can be different. For some applications, it may be desirable be to control the relative intensities of the light emitted by the front output 5 and the light emitted by the rear output 7 (for example to ensure that the pulse 23 and the pulse 25 enter the coupler 13 having substantially the same intensity). To this end, one or both optical channels 9, 11 may comprise an intensity controlling element (not shown in Figure 1) configured to control the intensity of the optical pulses propagating in the respective optical channel. Thus, the intensity controlling element can be operated to compensate for the unequal losses. The intensity controlling element may be implemented in any known and suitable manner, for example as an electro-absorption modulator, a Mach-Zehnder modulator, a semiconductor optical amplifier or an optical switch.

Additionally or alternatively, the coupler 13 may have an adjustable combining ratio (i.e. the combining ratio can be changed during use; typically by employing an electro-optic or a thermo-optic effect rather than by manually adjusting physical components of the coupler). In an embodiment, the coupler 13 may comprise a Mach-Zehnder interferometer for adjusting the combining ratio as illustrated in Figure 2. The Mach-Zehnder interferometer may comprise an input 2x2 coupler 13, whose outputs are optically coupled to an output 2x2 coupler 13a. A further phase controlling element 13₃ is provided in one arm of the Mach-Zehnder interferometer to control/adjust the combining ratio of the coupler 13. In this case, the controller 21 may be further configured to control or adjust the combining ratio of the coupler 13.

In the embodiment of Figure 1, the coupler 13 comprises two output ports that are respectively coupled to a first and a second optical output channel 17, 19. The output channels 17, 19 may be configured in a number of ways depending on specific requirements of the application for which the device 1 is used. As one example, one or both output channels 17, 19 may be coupled to respective out-couplers for providing an optical output of the device 1 (e.g. for down-stream use). For example, the out-coupler(s) may be a grating coupler for coupling the received signals into free-space or into an external optical fibre. As another example, one or both output channels 17, 19 may be coupled to respective photodetectors.

In embodiments, a polarisation controlling element may be provided in one or both optical channels 9, 11 (not shown in Figure 1). The polarisation controlling element(s) may be configured to control an optical polarisation of an optical pulse propagating in the respective channel. For example, the polarisation controlling element(s) may comprise polarising elements and/or polarisation rotating elements.

In embodiments, a frequency controlling element may be provided in one or both optical channels 9, 11 (not shown in Figure 1). The frequency controlling element may be configured to control the optical frequency of the coherent light propagating in the respective channel. For example, the frequency controlling element may be an electro-optical modulator (or an acousto-optical modulator) configured to modulate an optical frequency of the coherent light propagating in the respective channel. The frequency controlling element may be used to encode information into optical signals light propagating in the respective channel.

In embodiments, the second optical channel 11 may comprise a delay element (e.g. a delay line) configured to delay to an optical pulse (e.g. pulse 25) propagating in the first channel 11 with respect to an optical pulse (e.g. pulse 23) propagating in the first optical channel 9 by a delay time Δ_{delay}. In other embodiments, the delay element may be provided in the second channel 11 instead of in the first channel 9. In general, and as described below in more detail, the delay time Δ_{delay} of the delay element and the repetition rate of the laser 3 are typically jointly selected depending on the application for which the device 1 is to be used.

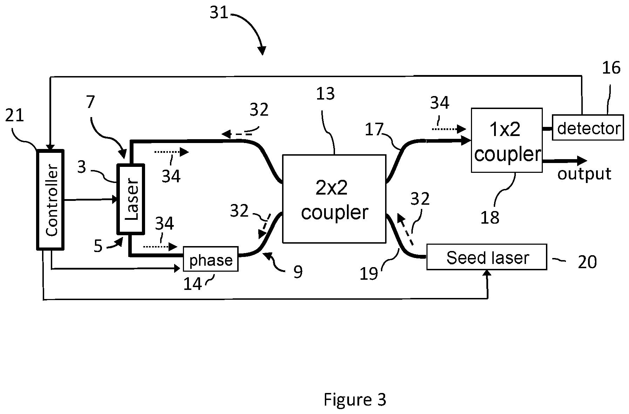

With reference to Figure 3, a further optical device 31 is described. Like the optical device 1 of Figure 1, the optical device 31 of Figure 3 comprises the semiconductor laser 3 with front and rear outputs 5, 7 coupled respectively to optical channels 9 and 17. Further like the optical device 1 of Figure 1, the optical device 31 of Figure 3 comprises the phase controlling element 14, the 2x2 coupler 13 with two output channels 17, 19, and a controller 21 for controlling the operation of the semiconductor laser 3 and the phase controlling element 14. The phase controlling element is controlled so that substantially all light emitted from the laser 3 is provided to the first output channel 17 of the combiner 13 (in Figure 3, the dotted arrows 34 indicate light emitted by the laser 3). In other words, the provided phase shift controls the interference between the light emitted from the front outputs 5 and the light emitted from the rear output 7 so that all light couples to the first output channel 17 and substantially no light emitted by the laser 3 exits the combiner 3 via the second output channel 19. To (actively) stabilise the phase difference between the optical channels 9, 11, the intensity the light exiting the combiner 3 via the first output channel 17 may be detected. To this end, the optical device 31 further comprises a 1x2 coupler which couples the optical channel 17 to i) a photodetector 16 and ii) to an output port (for use with downstream components/applications). The controller 21 may control the phase shifted provided by the phase controlling element 14 based on the detected intensity at photodetector 16.

The optical device 31 further comprises a seed laser 20 optically coupled to the second output channel 19 of the comber 13 (in Figure 3, the dashed arrows 32 indicate light emitted by the seed laser 20). The seed laser 20 is semiconductor laser configured to coherently seed the laser 3 by simultaneously injecting light into the laser 3 from both the front and the rear facet 5, 7. As a result of being coherently seeded by the seed laser 20, the laser 3 emits coherent light with a fixed frequency and phase relationship to light emitted by the seed laser 20. The operation of the seed laser 20 may be controlled by controller 21. Advantageously, the optical device 31 prevents the propagation of light emitted by laser 3 to the seed laser 20 (which would disturb the operation of the seed laser 20) without requiring a conventional optical isolator device. In embodiments, the optical device 31 further comprises a (e.g. fixed-value) optical attenuator in the second output channel 19 of the combiner 13 to reduce effects of light emitted by the seed laser 20 to propagate back into the seed laser 20.

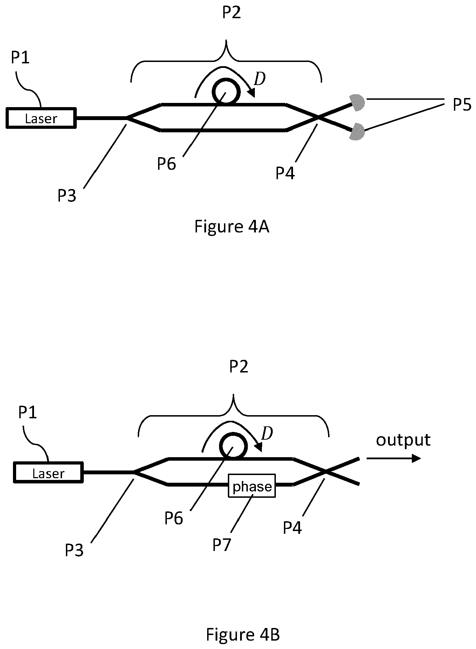

Before describing proposed embodiments relating to Quantum Random Number Generators (QRNG) and optical transmitters, designs of a conventional optical QRNG and a conventional quantum transmitter will now be described with reference to Figures 4A and 4B. Both of these conventional designs employ a laser that emits optical pulses into an input port of a time delay interferometer (also referred to as an asymmetric Mach Zehnder interferometer (AMZI)). More specifically, Figure 1A shows a portion of a conventional optical QRNG that comprises a single pulsed laser P1 driven at a fixed repetition rate to output a steam of pulses. When the repetition rate is low enough, each pulse from the stream of pulses may have a random phase. The pulses are coupled into the time delay interferometer P2 via an input coupler P3. The time delay interferometer P2 comprises a short and a long arm. The long arm of the time delay interferometer P2 comprises a delay element P6, which delays the pulses by a time D with respect to the pulses travelling in the short arm. In the QRNG device, the delay element P6 is configured such that the delay D introduced is such that each delayed pulse temporally overlaps with a previous reference pulse in the reference arm. The delayed and reference pulses interfere in a 2x2 coupler P4 (or beam splitter) of the time delay interferometer P2, and the interfered pulses are sent to photodetectors P5 where the intensities of the interfered pulses are converted to an electrical signal. This signal corresponding to the intensities of the interfered pulses has a random value because the phases of the reference and delayed pulses are random. Random numbers may be generated from the random intensities of the interfered pulses.

Figure 4B shows a conventional quantum key distribution (QKD) transmitter device. The device is suitable to emit time-bin encoded quantum signals to a corresponding quantum receiver. A time-bin encoded quantum signal is a pair of optical pulses with a well-defined temporal separation and with a well-controlled phase relationship. As before, the pulsed laser P1 emits optical pulses into the time delay interferometer P2. In Figure 4B, the repetition rate of the laser is lower than the delay time D, so that subsequently emitted pulses do not arrive simultaneously (and thus not interference) at the beam splitter P4. Instead each laser pulse is converted by the time delay interferometer P2 into in a pulse pair with a fixed temporal separation. The device further comprises a phase controlling element P7 to control a phase difference between the created pulse pair (i.e. to "encode" phase information into the pulse pair). The so-encoded time-bin quantum signals are then send to a quantum receiver.

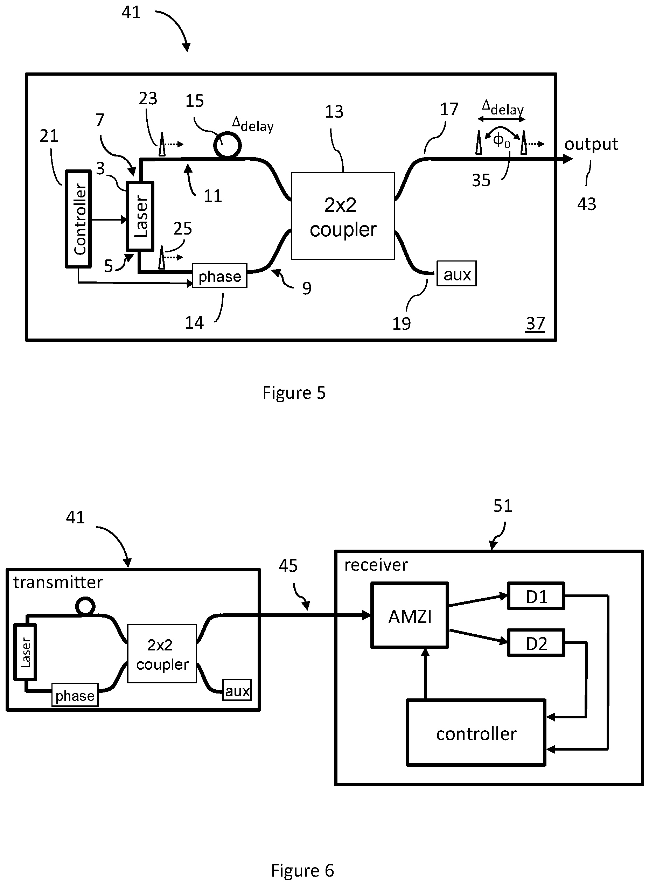

The "footprint" of the optical devices of Figures 4A and 4B can be reduced by using a laser with two output ports as described in the following with reference to Figures 5 to 8 (reducing the footprint of optical QRNGs and optical quantum transmitters is advantageous since this supports large-scale deployment). The term "footprint" may generally refer to the size of the device, e.g. to an area or volume that the device occupies.

With reference to Figure 5, an optical quantum transmitter 41 for quantum communication is described (e.g. the optical quantum transmitter 41 may be used to implement a quantum key distribution protocol). In a quantum communication system, information is sent between a transmitter and a receiver by encoded single quanta, such as single photons. Each photon carries one bit of information encoded upon a property of the photon, such as its polarization, phase or energy/time. A quantum communication system may be used to implement quantum key distribution (QKD) which is a technique for sharing of cryptographic keys between two parties; a transmitter, often referred to as "Alice", and a receiver, often referred to as "Bob". The attraction of QKD is that it provides a test of whether any part of the key can be known to an unauthorised eavesdropper, often referred to as "Eve". For example, a quantum communication system comprising the above described multi-beam OPA may implement a BB84 protocol [C. H. Bennett and G. Brassard, Proc. of IEEE Int. Conf. on Comp. Sys. Sign. Process. (IEEE, New York, 1984), pp. 175-179] or a distributed phase reference protocol (such as a coherent one-way protocol or a differential-phase-shift protocol).

A QKD protocol typically involves two steps. First, Alice sends quantum information to Bob through a quantum channel, then, during a post-processing stage, Alice and Bob communicate with each other through a classical channel to establish the shared key. The quantum channel (sent from the transmitter to the receiver) may be encoded in a number of ways, for example in phase (i.e. time-bin encoding) or in polarisation. Time-bin encoding means that the quantum transmitter provides pairs of (short) optical pulses with a well-defined temporal separation and with a well-controlled phase relationship.

The optical transmitter 41 of Figure 5 is configured to emit time-bin encoding quantum signals to a quantum channel (e.g. a free-space channel or an optical fibre) at output port 43. It is to be understood that such quantum signals typically have mean photon numbers of less than one photon per quantum signal.

Like the optical device 1 of Figure 1, the optical device 41 of Figure 5 comprises the semiconductor laser 3 with front and rear outputs 5, 7 coupled respectively to optical channels 9 and 17. Further like the optical device 1 of Figure 1, the optical device 41 of Figure 5 comprises the phase controlling element 14, the 2x2 coupler 13 with two output channels 17, 19, and a controller 21 for controlling the operation of the semiconductor laser 3 and the phase controlling element 14. The optical device 41 comprises in the second optical channel a delay element 15 (e.g. a delay line) configured to delay to an optical pulse (e.g. pulse 25) propagating in the second channel 11 with respect to an optical pulse (e.g. pulse 23) propagating in the first optical channel 9 by a delay time Δ_{delay}. The components of the optical transmitter 41 are integrated on a common semiconductor substrate 37 (or on multiple semiconductor substrates that are appropriately assembled/connected).

To implement time-bin-encoding, the laser 3 is operated to emit a stream of short laser pulse emitted with a controlled time delay between the light pulses in each pair. More specially, the laser 3 is gain-switched to output a stream of phase randomised pulses (i.e. each pulse from the stream of pulses may have a random phase). The laser 3 may be pulsed at a fixed repetition rate, i.e. subsequently emitted pulses may have a corresponding temporal spacing denoted Δₗₐₛₑᵣ. The repetition rate of the laser 3 is selected such that the temporal spacing Δₗₐₛₑᵣ is longer than the delay time Δ_{delay}.

During operation of the optical transmitter 41, the laser 3 simultaneously emits the pulse 25 from the front output 5 and the pulse 23 from the rear output 7. The pulse 23 emitted from the rear output 7 is delayed by Δ_{delay}, and thus, at the output channel 17 of the coupler 13, a pulse pair with fixed temporal spacing is provided. As described above, the pulses 23, 25 are emitted in a common lasing process and have a fixed phase relation to each other. Thus, the phase controlling element 14 can be used to adjust the phase between the pulses 23, 25 to generate a particular time-bin encoded quantum state. As illustrated in Figure 5, the resulting time-bin encoded quantum state 35 provided at the output port 43 comprises the temporally spaced pulse pair 23, 25 having a well-defined phase difference φ₀.

In particular, to implement the aforementioned BB84 protocol, the quantum transmitter 41 may be configured to (at each cycle of the repetition rate) randomly a phase between pulses in the same pair from a set of phase differences. In an embodiment, the set of phase differences may comprise 0, π/2, π and 3π/4. As described above, the laser 3 may be operated that there is a random phase difference between pulses from different pairs (it is known that it is desirable to randomise the phase between consecutive pulse-pairs to increase the security of the protocol).

Advantageously, the optical transmitter 41 can be implemented in a more compact manner than the known design of Figure 4B (e.g. for one thing the beam splitter P3 is not required in the embodiment of Figure 5).

Figure 6 shows a quantum communication system is which the optical transmitter 41 is used to emit time-bin encoded quantum states via a quantum channel 45 (e.g. a free-space link or an optical fibre) to a quantum receiver 51 (e.g. to implement a QKD protocol). The quantum receiver 51 is generally of known design. The quantum receiver comprises an asymmetric Mach-Zehnder interferometer AMZI (also referred to as decoding Mach-Zehnder interferometer) having a long and a short arm with an adjustable phase difference between the two arms. The time delay of the AMZI matches the time delay Δ_{delay} of the delay element 15 of the optical transmitter 41. The outputs of AMZI are coupled to photodetectors D1, D2. The receiver 51 also comprises a controller which selects the measurement basis by controlling the phase difference of the AMZI and which records the detection events of the photodetectors D1, D2. As described above, the optical transmitter 41 and the receiver 51 are also in communication via a classical channel (not shown in Figure 6).

In an embodiment, the optical transmitter 41 may further comprise an intensity controlling element (not shown in Figure 5) coupled between the combiner 13 and the output port 43 configured to control the intensity of the created pulse pair 35. The intensity controlling element may be implemented in any known and suitable manner, for example as an electro-absorption modulator, a Mach-Zehnder modulator, a semiconductor optical amplifier or an optical switch. Additionally or alternatively, the optical transmitter 41 may further comprise a further phase controlling element (not shown in Figure 5) coupled between the combiner 13 and the output port 43 configured to control (i.e. further randomise) a global phase of the created pulse pair 35.

Whilst the optical transmitter 41 has been described as emitting time-bin encoding quantum signals, various modifications will be apparent to those skilled in the art. For example, the optical transmitter 41 may implement a different encoding (i.e. a quantum state encoding technique other than time-bin encoding). As a first example, a variation of the optical transmitter 41 (not shown in the Figures) may emit polarisation encoded quantum states. In this variation, the time delay element may be absent and the optical transmitter may further comprise a polarisation controlling element (e.g. coupled between the combiner 13 and the output port 43 configured to control a polarisation of optical pulses emitted by laser 3). As a second example, a variation of the optical transmitter 41 (not shown in the Figures) may emit frequency-encoded quantum states. In this variation, the time delay element may be absent and the optical transmitter may further comprise (in the first or the second optical channel 9, 11) a frequency controlling element for controlling a frequency shift between light propagating the first and second optical channels 9, 11. As a third example, a variation of the optical transmitter 41 (not shown in the Figures) may emit phase-encoded quantum states. In this variation, the time delay element may be absent and the optical transmitter may further comprise a phase controlling element (e.g. coupled between the combiner 13 and the output port 43 configured to control a phase of optical pulses emitted by laser 3). Further in this variation, the laser 3 may not be configured to emit a stream of phase randomised pulses. Instead, the laser 3 may be configured to emit a stream of pulses which have a well-defined phase relationship (e.g. the laser 3 may be injection-locked to a reference laser which provides a stable phase and frequency reference to the laser 3). As a fourth example, a variation of the optical transmitter 41 (not shown in the Figures) may emit path-encoded quantum states. In this variation, the time delay element may be absent and the optical transmitter may further comprise a second output port coupled to the second output channel 19 of the combiner 13. In this variation, the phase controlling element 14 may be used to encode path information, i.e. by controlling the phase difference between corresponding pulses propagating in the channels 7, 11, the phase controlling element 14 controls the interference of the pulses at the combiner 13 and consequently the output port to which the interfered light propagates.

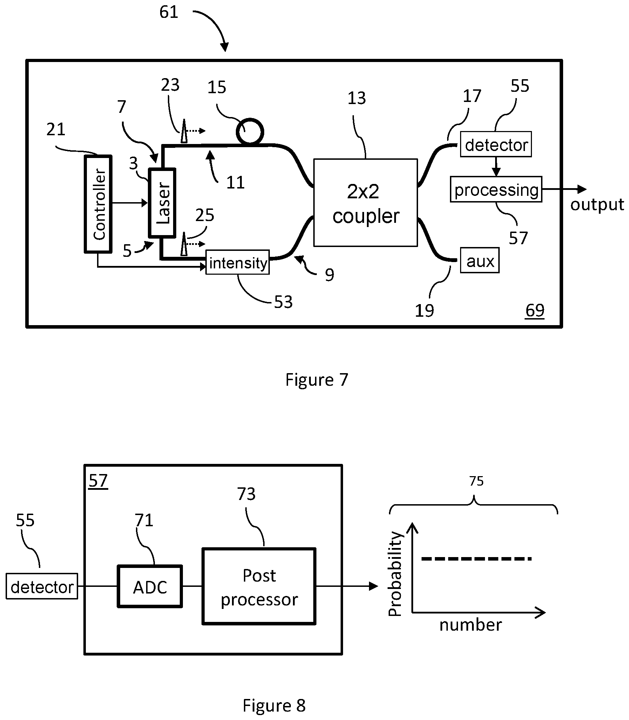

An optical quantum random number generator (QRNG) 61 will now be described with reference to Figures 7 and 8. In general, the QRNG 61 is configured to generate (and output) random numbers from the random intensity of interfered optical pulses. The QRNG is provided as an integrated device, i.e. the components of the QRNG 61 are integrated on a common semiconductor substrate 69 (or on multiple semiconductor substrates that are appropriately assembled/connected).

Like the optical device 1 of Figure 1, the QRNG 61 of Figure 7 comprises the semiconductor laser 3 with front and rear outputs 5, 7 coupled respectively to optical channels 9 and 17. Further like the optical device 1 of Figure 1, the QRNG 61 comprises the 2x2 coupler 13 with two output channels 17, 19, and in the second optical channel a delay element 15 (e.g. a delay line) configured to delay to an optical pulse (e.g. pulse 25) propagating in the first channel 11 with respect to an optical pulse (e.g. pulse 23) propagating in the first optical channel 9 by a delay time Δ_{delay}.

The laser 3 is operated to emit a stream of short laser pulse emitted with a controlled time delay between the light pulses in each pair. More specially, the laser 3 is gain-switched to output a stream of phase randomised pulses (i.e. each pulse from the stream of pulses may have a random phase). The laser 3 may be pulsed at a fixed repetition rate, i.e. subsequently emitted pulses may have a corresponding temporal spacing denoted Δₗₐₛₑᵣ. The repetition rate of the laser 3 is selected such that the delay time Δ_{delay} is an integer multiple of the temporal spacing Δₗₐₛₑᵣ (e.g. the temporal spacing Δₗₐₛₑᵣ can be equal to the delay time Δ_{delay}, or the delay time Δ_{delay} can be twice the temporal spacing Δₗₐₛₑᵣ, and so one). In this way, pulse emitted from the rear output 7 is delayed by the delay element to interfere with a non-delayed pulse emitted from the front output 5 at the combiner 13. The phases of the delayed and non-delayed pulses are random (since these pulses are not generated in the same lasing process) and thus the intensities of the interfered pulses (e.g. at the first output channel 17 of the combiner 13) have random values. Random numbers may be generated from the random intensities of the interfered pulses.

It is to be understood that in other embodiments, the laser 3 of the QRNG 61 may be operated in a continuous wave mode. In this case, the delay time Δ_{delay} is selected to be longer than the coherence time of the laser 3, so that the intensity of the interfered light is random.

Referring back to Figure 7, the QRNG 61 further comprises, in the first optical channel 9, an intensity controlling element 53 configured to control the intensity of the optical pulses propagating in the respective optical channel. Thus, the intensity controlling element can be operated to compensate for unequal losses in the first and second optical channel 9, 11 (e.g. to compensate for additional losses in the second channel 7 caused by the delay element 15). The intensity controlling element 53 may be implemented in any known and suitable manner, for example as an electro-absorption modulator, a Mach-Zehnder modulator, a semiconductor optical amplifier or an optical switch.

The QRNG 61 further comprises the controller 21 for controlling the operation of the semiconductor laser 3 and the intensity controlling element 53.

The QRNG 61 further comprises, optically coupled to the output channel 17 of the combiner 13, a photodetector 55 configured to convert the random intensities of interfered optical pulses into electrical signals (e.g. photodetector 55 may be a InP based on-chip photodiode). The photodetector 55 is coupled to a processing unit 57 configured to extract random numbers from the electrical signals generated by the photodetector 55. To this end, the processing unit 57 may process the numerical values provided by the photodetector 55 with a randomness extractor algorithm. More specifically, as shown in Figure 8, the processing unit 57 may comprise an analog-to-digital converter (ADC) 71 that is further coupled to a post processor 73. The ADC 71 may convert analog electrical signals received from the photodetector 55 into digital signals which are provided to the post processor 73. The output of the post processor 73 is a sequence of random numbers having a uniform probability distribution 75.

Advantageously, the QRNG 61 can be implemented in a more compact manner than the known design of Figure 4A (e.g. for one thing the beam splitter P3 is not required in the embodiment of Figure 7).

Further embodiments are set out in the following clauses.
1. An optical device comprising:
   a semiconductor laser having a first output facet and a second output facet, and the laser being configured to emit coherent light from both the first output facet and the second output facet;
   a first optical channel coupled to the first output facet of the laser;
   a second optical channel coupled to the second output facet of the laser; and
   an optical combiner configured to combine the first and the second optical channel into a combiner output channel.
2. The optical device of clause 1, wherein the first output facet is a front facet of the laser and the second output facet is a rear facet of the laser.
3. The optical device of clause 1 or 2, wherein the first or the second optical channel comprises a delay element.
4. The optical device of clause 3, wherein the delay element comprises a delay line.
5. The optical device of any preceding clause, wherein the first or the second optical channel comprises a polarisation controlling element configured to control an optical polarisation of the coherent light propagating in the respective channel.
6. The optical device of any preceding clause, wherein the first or the second optical channel comprises a frequency controlling element configured to control the optical frequency of the coherent light propagating in the respective channel.
7. The optical device of any preceding clause, wherein the first or the second optical channel comprises an intensity controlling element configured to control the intensity of the coherent light propagating in the respective optical channel.
8. The optical device of clause 7, wherein the intensity control element comprises at least one of an electro-absorption modulator, a Mach-Zehnder modulator, a semiconductor optical amplifier or an optical switch.
9. The optical device of any preceding clause, wherein the first or the second optical channel comprises a phase controlling element configured to provide a phase shift to the coherent light propagating in the respective channel.
10. The optical device of any preceding clause, wherein the optical combiner is an adjustable optical combiner configured to combine, based on an adjustable combining ratio, the coherent light emitted by the first and the second optical channel into the combiner output channel.
11. The optical device of clause 10, wherein the adjustable optical combiner comprises a first and a second combiner output channel, and the adjustable optical combiner is configured to combine the coherent light emitted by the first and the second optical channel into the first and second combiner output channels based on the adjustable combining ratio.
12. The optical device of clause 10 or 11, wherein the optical combiner comprises a Mach-Zehnder interferometer for adjusting the combining ratio.
13. The optical device of any preceding clause, wherein the semiconductor laser is a distributed feedback laser or a Fabry-Pérot laser diode.
14. The optical device of any preceding clause, wherein the semiconductor laser is a gain-switched laser and configured to emit the stream of optical pulses such that the phase of each pulse in the stream of pulses is randomised.
15. The optical device of any preceding clause further comprising an optical detector coupled to the combiner output channel.
16. The optical device of any preceding clause further comprises a seed laser optically coupled to the combiner output channel to simultaneously seed the semiconductor laser via the first output facet and via the second output facet.
17. The optical device of any preceding clause, wherein the first or the second optical channel comprises a phase controlling element configured to provide a phase shift to the coherent light propagating in the respective channel, and the optical combiner comprises a first and a second combiner output channel and the phase shift provided by the phase controlling element is selected so that, at the optical combiner, light from the first and second optical channels interferes to be combined into only one of the first and a second combiner output channels.
18. The optical device of any preceding clause further comprising a semiconductor substrate, and wherein the semiconductor laser, the first and second optical channels and the optical combiner are integrated on the semiconductor substrate to form a photonic integrated circuit.
19. An optical quantum random number generator comprising:
   an optical device of clause 15, and
   processing circuitry to generate random numbers from numerical values provided by the optical detector,
20. The optical quantum random number generator of clause 19, wherein the semiconductor laser is a gain-switched laser and configured to emit the stream of optical pulses such that the phase of each pulse in the stream of pulses is randomised, and the first or the second optical channel comprises a delay element providing a delay time equal to an integer multiple of a temporal separation between pulses in the stream of pulses emitted by the gain-switched laser.
21. The optical quantum random number generator of clause 20, wherein the delay element provides a delay time equal to the temporal separation between pulses in the stream of pulses emitted by the gain-switched laser so that successive optical pulses are interfered by the optical combiner to convert a phase difference between successive optical pulses into an intensity modulation of an output optical signal provided to the optical detector via the combiner output channel.
22. An optical transmitter for quantum communication comprising the optical device of any one of clauses 1 to 18.
23. The optical transmitter of clause 22 configured to generate time-bin encoded quantum states so that an optical pulse emitted from the first output facet of the laser and a corresponding pulse emitted from the second facet output of the laser form a time-bin encoded quantum state.
24. The optical transmitter of clause 22 configured to generate frequency-encoded quantum states so that an optical pulse emitted from the first output facet of the laser and a corresponding pulse emitted from the second facet output of the laser form a frequency-encoded quantum state.
25. The optical transmitter of clause 22 configured to generate, from an optical pulse emitted from the first output facet of the laser and a corresponding pulse emitted from the second facet output of the laser, a phase-encoded quantum state.
26. The optical transmitter of clause 22 configured to generate, from an optical pulse emitted from the first output facet of the laser and a corresponding pulse emitted from the second facet output of the laser, a polarisation-encoded quantum state.
27. The optical transmitter of clause 22 configured to generate, from an optical pulse emitted from the first output facet of the laser and a corresponding pulse emitted from the second facet output of the laser, a path-encoded quantum state.

Whilst certain embodiments have been described, these embodiments have been presented by way of example only, and are not intended to limit the scope of the inventions. Indeed, the novel devices, and methods described herein may be embodied in a variety of other forms; furthermore, various omissions, substitutions and changes in the form of the devices, methods and products described herein may be made without departing from the spirit of the inventions. The accompanying claims are intended to cover such forms or modifications as would fall within the scope and spirit of the inventions.

## Claims

1. An optical device comprising:
a semiconductor laser having a first output facet and a second output facet, and the laser being configured to emit coherent light from both the first output facet and the second output facet;
a first optical channel coupled to the first output facet of the laser;
a second optical channel coupled to the second output facet of the laser; and
an optical combiner configured to combine the first and the second optical channel into a combiner output channel.

2. The optical device of claim 1, wherein the first output facet is a front facet of the laser and the second output facet is a rear facet of the laser.

3. The optical device of claim 1 or 2, wherein the first or the second optical channel comprises at least one of:
a delay element; a polarisation controlling element configured to control an optical polarisation of the coherent light propagating in the respective channel;
a frequency controlling element configured to control the optical frequency of the coherent light propagating in the respective channel;
an intensity controlling element configured to control the intensity of the coherent light propagating in the respective optical channel; or
a phase controlling element configured to provide a phase shift to the coherent light propagating in the respective channel.

4. The optical device of any preceding claim, wherein the optical combiner is an adjustable optical combiner configured to combine, based on an adjustable combining ratio, the coherent light emitted by the first and the second optical channel into the combiner output channel.

5. The optical device of claim 4, wherein the adjustable optical combiner comprises a first and a second combiner output channel, and the adjustable optical combiner is configured to combine the coherent light emitted by the first and the second optical channel into the first and second combiner output channels based on the adjustable combining ratio.

6. The optical device of claim 4 or 5, wherein the optical combiner comprises a Mach-Zehnder interferometer for adjusting the combining ratio.

7. The optical device of any preceding claim, wherein the semiconductor laser is a distributed feedback laser, Fabry-Pérot laser diode or a gain-switched laser and configured to emit the stream of optical pulses such that the phase of each pulse in the stream of pulses is randomised.

8. The optical device of any preceding claim further comprising an optical detector coupled to the combiner output channel.

9. The optical device of any preceding claim further comprises a seed laser optically coupled to the combiner output channel to simultaneously seed the semiconductor laser via the first output facet and via the second output facet.

10. The optical device of any preceding claim, wherein the first or the second optical channel comprises a phase controlling element configured to provide a phase shift to the coherent light propagating in the respective channel, and the optical combiner comprises a first and a second combiner output channel and the phase shift provided by the phase controlling element is selected so that, at the optical combiner, light from the first and second optical channels interferes to be combined into only one of the first and a second combiner output channels.

11. The optical device of any preceding claim further comprising a semiconductor substrate, and wherein the semiconductor laser, the first and second optical channels and the optical combiner are integrated on the semiconductor substrate to form a photonic integrated circuit.

12. An optical quantum random number generator comprising:
an optical device of claim 8, and
processing circuitry to generate random numbers from numerical values provided by the optical detector,

13. The optical quantum random number generator of claim 12, wherein the semiconductor laser is a gain-switched laser and configured to emit the stream of optical pulses such that the phase of each pulse in the stream of pulses is randomised, and the first or the second optical channel comprises a delay element providing a delay time equal to an integer multiple of a temporal separation between pulses in the stream of pulses emitted by the gain-switched laser.

14. The optical quantum random number generator of claim 13, wherein the delay element provides a delay time equal to the temporal separation between pulses in the stream of pulses emitted by the gain-switched laser so that successive optical pulses are interfered by the optical combiner to convert a phase difference between successive optical pulses into an intensity modulation of an output optical signal provided to the optical detector via the combiner output channel.

15. An optical transmitter for quantum communication comprising the optical device of any one of claims 1 to 18.

16. The optical transmitter of claim 15, configured to generate:
time-bin encoded quantum states so that an optical pulse emitted from the first output facet of the laser and a corresponding pulse emitted from the second facet output of the laser form a time-bin encoded quantum state;
frequency-encoded quantum states so that an optical pulse emitted from the first output facet of the laser and a corresponding pulse emitted from the second facet output of the laser form a frequency-encoded quantum state;
from an optical pulse emitted from the first output facet of the laser and a corresponding pulse emitted from the second facet output of the laser, a phase-encoded quantum state;
from an optical pulse emitted from the first output facet of the laser and a corresponding pulse emitted from the second facet output of the laser, a polarisation-encoded quantum state; or
from an optical pulse emitted from the first output facet of the laser and a corresponding pulse emitted from the second facet output of the laser, a path-encoded quantum state.
